Europäisches Patentamt

European Patent Office

Office européen des brevets

(11) Publication number: **0 471 126 A2**

# EUROPEAN PATENT APPLICATION

(21) Application number: **90312997.1**

(22) Date of filing: **29.11.90**

(51) Int. Cl.5: **G11C 11/412**

(30) Priority: **15.08.90 US 568296**

(43) Date of publication of application:
**19.02.92 Bulletin 92/08**

(84) Designated Contracting States:
**DE FR GB IT**

(71) Applicant: **SAMSUNG SEMICONDUCTOR, INC.**
**3725 North First Street**
**San Jose, California 95134-1708(US)**

(72) Inventor: **Hwang, Stephen**
**1892 Oldbridge Road**
**San Jose, California 95131(US)**
Inventor: **Wang, Alex C.**
**147 Declaration Court**
**San Jose, California 95116(US)**

(74) Representative: **Jones, Ian et al**
**W.P. THOMSON & CO. High Holborn House**
**52-54 High Holborn**
**London WC1V 6RY(GB)**

(54) **Static random access memory cell.**

(57) An SRAM cell includes two cross coupled drive transistors, each having associated therewith an access transistor connected to bit and word lines, and a thin film transistor load connected to a voltage source. As the drive transistors are cross coupled, the left branch drive transistor is switched by the voltage at the drain of the right branch drive transistor, and the right branch drive transistor is switched by the voltage at the drain of the left branch drive transistor. The SRAM cell is laid out such that the left branch thin film transistor is gated by the gate of the right branch drive transistor, and the right branch thin film transistor is gated by the gate of the left branch drive transistor. Accordingly, when the left branch drive transistor is ON, for example, the left branch thin film transistor presents a high resistance to limit the standby current flowing through the left branch. At the same time, the right branch drive transistor is OFF and the right branch thin film transistor is ON. The ON right branch thin film transistor is capable of driving sufficient current to the right branch drive transistor so that the right branch drive transistor is not easily able to pull down its drain node, which contributes to cell stability.

FIG. 3

This invention relates to static random access memory cells.

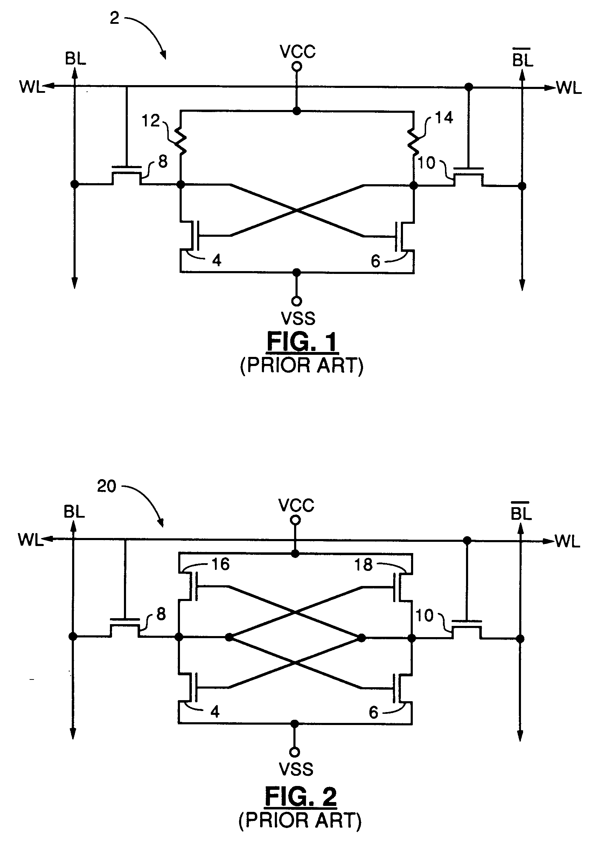

Reference is now made to Figures 1 or 2 of the accompanying drawings, wherein like reference numerals indicate like parts, and wherein Figure 1 is a circuit schematic diagram showing a prior art high resistivity SRAM cell, and Figure 2 is a circuit schematic diagram showing a prior art six transistor SRAM cell with PMOS transistors replacing the load resistors of Figure 1.

The common form of static random access memory ("SRAM") cell 2 shown in Figure 1 is generally known as a high resistivity load cell. Transistors 4 and 6 are NMOS driver transistors, transistors 8 and 10 are NMOS access transistors, and resistors 12 and 14 are high resistivity polysilicon resistors. Various design considerations and a schematic cross section of one such high resistivity load cell are given in M. Kakumu et al., "0.5 um Gate 1M SRAM with High Performance at 3.3V," 1989 Symposium on VLSI Technology, Digest of Technical Papers, Kyotto, Japan, November 22-25, 1989, session 8-2, pp. 63-64.

While the high resistivity load cell 2 is particularly useful in high density SRAMs (e.g., one Megabit) because of its small area, its stability and standby current consumption, are generally unsatisfactory for higher memory densities, notably for 4 megabit designs. This is the case, for example, with designs in which the load resistors are located at least in part over active areas of the integrated circuit. Nonetheless, the high resistivity load cell 2 has been extended to a four Megabit memory design by the use of four level polysilicon, including two polycide layers, and two level aluminum CMOS process technology. See K. Yuzuriha et al., "A New Process Technology for a 4Mbit SRAM with Polysilicon Load Resistor Cell," 1989 Symposium on VLSI Technology, Digest of Technical Papers, Kyotto, Japan, November 22-25, 1989, session 8-1, pp. 61-62.

Alternatives to the high resistivity load cell 2 have been developed. A SRAM cell having a conventional six-transistor, cross-coupled flip-flop and n-channel depletion load devices fabricated in the substrate is disclosed in Poshley et al., "Speedy RAM runs cool with power-down circuitry," Electronics, August 4, 1977, pp. 103-07. In the six transistor circuit 20 shown in Figure 2, p-channel transistors 16 and 18 replace the polysilicon resistors 12 and 14 of the high resistivity load cell 2 of Figure 1 to achieve minimum power dissipation at the expense of an increased cell size. Cell area can be reduced somewhat by the use of CMOS cells with polysilicon p-channel load transistors and stacked cross-coupled capacitors, as described in T. Yamanaka et al., "A 25um$^2$, New Poly-Si PMOS Load (PPL) SRAM Cell Having Excellent Soft Error Immunity," IEDM Technical Digest, International Electron Devices Meeting, San Francisco, December 11-14, 1988, pp. 48-51.

Thin film transistors also have found application in SRAM cells. A four Megabit SRAM having PMOS-type thin film transistor load cells is described in S. Hayakawa et al., "A 1uA Retention 4Mb SRAM with a Thin Film Transistor Load Cell," IEEE International Solid State Circuits Conference, February 15, 1990, pp. 128-29. The n + diffusion area of the driver transistor in this design acts as a gate electrode for the PMOS thin film transistor.

Despite these developments, the need continues for the realization of high SRAM cell densities in other semiconductor fabrication processes.

The present invention realizes high SRAM cell densities as well as low standby current and good stability by the use of NMOS thin film transistors. In one embodiment, the present invention includes a first drive transistor, a second drive transistor cross coupled to the first drive transistor, a first thin film transistor connected in the drain circuit of the first drive transistor and gated by the gate of the second drive transistor and a second thin film transistor connected in the drain circuit of the second drive transistor and gated by the gate of the first drive transistor.

The invention is further described below, by way of example, with reference to Figures 3-10 of the accompanying drawings wherein like reference numerals indicate like parts and wherein:

Figure 3 is a circuit schematic diagram showing a SRAM cell in accordance with the present invention;

Figure 4 is a layout diagram for a portion of the SRAM cell of Figures 3;

Figures 5 and 6 are cross section diagrams of a partially completed SRAM cell of the type shown in Figure 3, taken along lines F5:F5 and F6:F6 of Figure 4;

Figures 7 and 8 are cross section diagrams of a SRAM cell of the type shown in Figure 3, taken along line F5:F5 during intermediate stages of fabrication of the SRAM cell;

Figure 9 is a cross section diagram of a patially completed variation of the SRAM cell of the type shown in Figures 4-6; and

Figure 10 is a circuit schematic diagram of the SRAM cell of Figure 9.

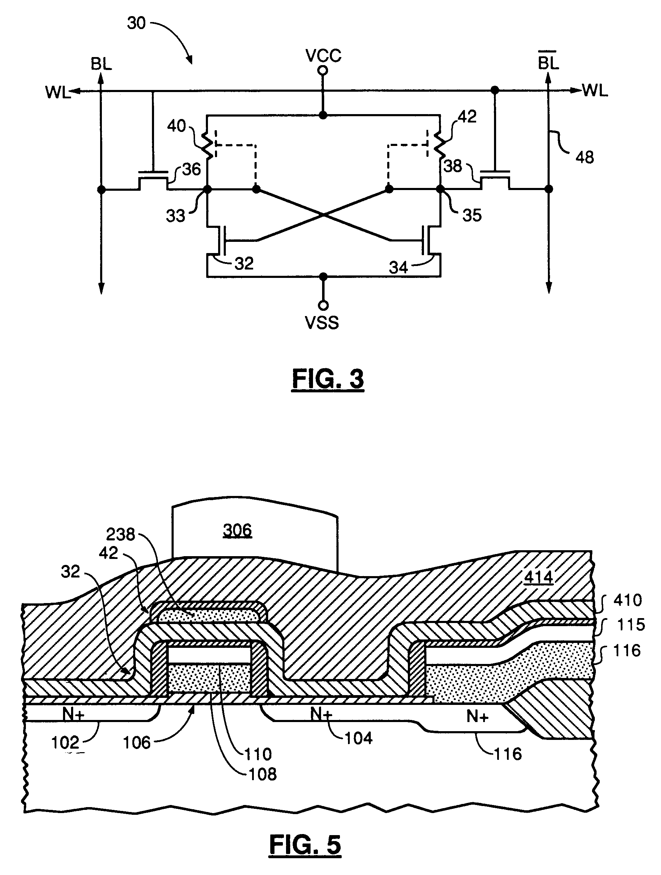

The SRAM cell 30 of figure 3 has two branches. The left branch includes NMOS driver transistor 32, NMOS access transistor 36, and load 40, a n-channel depletion-mode thin film transistor. One terminal of load 40 , the drain of transistor 32, and the source of transistor 36 are connected at node 33. Bit line BL is connected to the drain of the access transistor 36, and word line WL is connected to its gate. The right branch includes NMOS driver transistor 34, NMOS access transistor 38, and load 42, a n-channel depletion-mode thin film transistor. One terminal of load 42, the drain of transistor 34, and the source of transistor 38 are connected at node 35. Bit line BL complement is connected to the drain of the access transistor 38, and word line WL is connected to its gate. Voltage $V_{CC}$ is supplied to the common node of the loads 40 and 42. Voltage $V_{SS}$ is supplied to the common node of the sources of drive transistors 32 and 34.

Drive transistors 32 and 34 are cross coupled. Hence, the right branch drive transistor 34 is switched by the voltage at the left branch node 33, and the left branch drive transistor 32 is switched by the voltage at node 35.

The left branch load 40, a thin film transistor, is gated in the same manner as is the right branch drive transistor 34. In the cell layout described below, both transistors 34 and 40 are gated by the same gate, which is responsive to the voltage at the left branch node 33. When the voltage at node 33 is LOW (left branch drive transistor 32 being ON), thin film transistor 40 is OFF and limits the current flowing through the left branch. This feature contributes to the low standby current exhibited by the SRAM cell 30. When the voltage at node 33 is HIGH (left branch drive transistor 32 being OFF), thin film transistor 40 is ON and is capable of supplying current to the node 33. The amount of current that thin film transistor 40 is capable of supplying is sufficiently great so that drive transistor 32 is not easily able to pull down node 33. This feature contributes to the stability exhibited by the SRAM cell 30.

The right branch load 42, a thin film transistor, is gated in the same manner as is the left branch drive transistor 32. In the cell layout described below, both transistors 32 and 42 are gated by the same gate, which is responsive to the voltage at the right branch node 35. Accordingly, low standby current and enhanced stability are achieved in a complementary manner in the left and right branches of the memory cell 30.

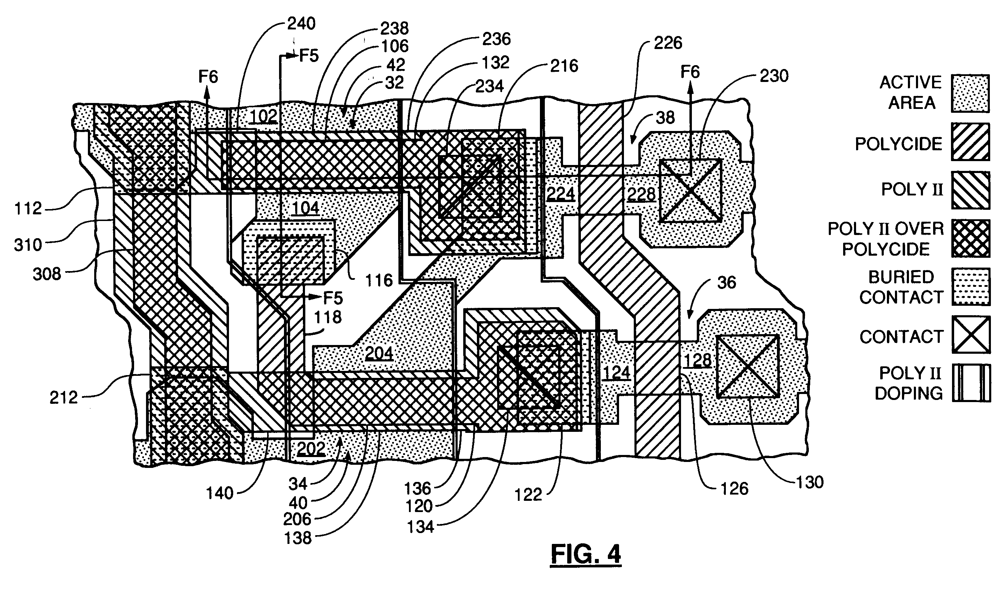

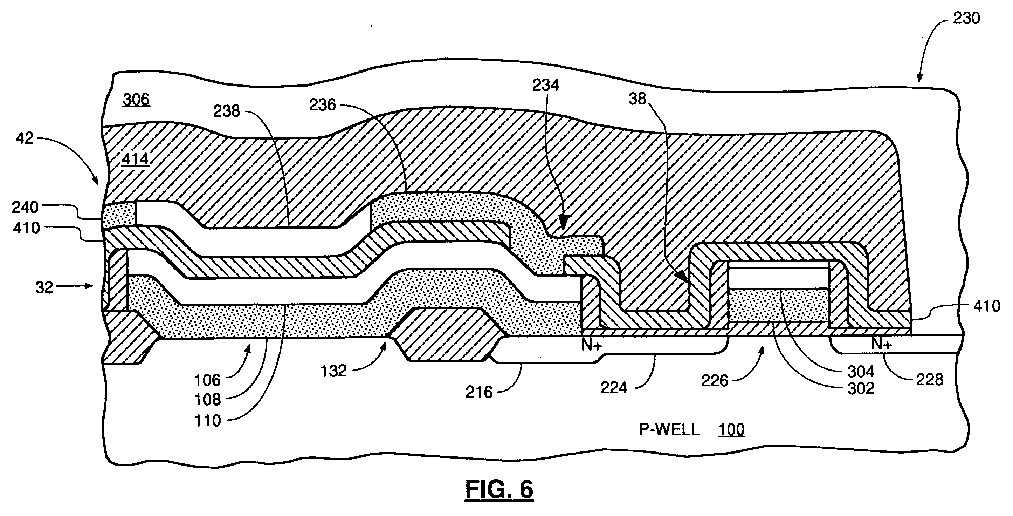

A composite layout diagram of the active area mask, the polycide mask, the poly II mask, the buried contact mask, the contact hole mask, and the poly II doping mask for an illustrative cell 30 is shown in Figure 4. Cross section views of an integrated circuit fabricated in accordance with the masks of Figure 4 are shown in Figures 5 and 6, which correspond to the sections taken along F5:F5 and F6:F6 in Figure 4.

The SRAM cell 30 left branch drive transistor 32 shown in cross section in Figure 5 includes source region 102, drain region 104, and a gate 106 having a first polysilicon portion 108 overlaid by a tungsten silicide portion 110. The source 102 of left branch drive transistor 32 is connected to first poly $V_{SS}$ line 308 through a buried contact 112 (Figure 4). The drain 104 of left branch drive transistor 32 is connected to the source 124 of left branch access transistor 36 through a buried contact 116, three segments 118, 206, and 120 of a continuous conductive structure having a first polysilicon portion 114 overlaid by a tungsten silicide portion 115, and a buried contact 122. Segments 118 and 120 are interconnect segments, while segment 206 functions as the gate of right branch drive transistor 34 and the gate of the left branch thin film load transistor 40, as explained below. The gate 126 of the left branch access transistor 36 is a segment of word line 300, which has a first polysilicon portion 302 overlaid by a tungsten silicide portion 304. The drain 128 of the left branch access transistor 36 is connected to a metal bit line (not shown) through a contact hole 130.

The SRAM cell 30 right branch drive transistor 34 (not shown in cross section) includes source region 202, drain region 204, and a gate 206 having a first polysilicon portion 114 overlaid by a tungsten silicide portion 115. The source 202 of right branch drive transistor 34 is connected to the first poly $V_{SS}$ line 308 through a buried contact 212 (Figure 4). The drain 204 of right branch drive transistor 34 is connected to the source 224 of right branch access transistor 38 through a doped portion of a common active region that includes buried contact 216. The gate 226 of the right branch access transistor 38 is a segment of word line 300, which has first polysilicon portion 302 overlaid by a tungsten silicide portion 304. The drain 228 of the right branch access transistor 36 is connected to metal bit line complement 306 through a contact hole 230.

Low standby current and enhanced stability are achieved by having the right branch thin film load transistor 42 gated by the same voltage as gates the left branch drive transistor 32, while the left branch thin film load transistor 40 is gated by the same voltage as gates the right branch drive transistor 34. In a SRAM cell 30 fabricated in accordance with the layout diagram of Figure 4, this gating technique is achieved by forming undoped channel regions for the left and right branch thin film load transistors 40 and 42 in second poly, and locating these channel regions over respectively the gates of the right and left branch drive transistors 34 and 32. The imposition of the gates of the right and left branch drive transistors 34 and 32 between the channel regions of the thin film load transistors 40 and 42 and the active areas of the substrate 100 ensures that the channel regions of the thin film load transistors 40 and 42 are not gated by the active areas of the substrate 100.

The gate of the left branch drive transistor 32 is shown as segment 106 of a conductive structure also comprising a segment 132, which contacts the drain 204 of the right branch drive transistor 34 through the buried contact 216. The buried contact 216, hence drain 204, also is contacted by a source region 236 of the right branch thin film load transistor 42, fabricated in second polysilicon, through a contact hole 234 to the conductive segment 132. The source 236 is continuous with an undoped second polysilicon section 238, which is disposed on a dielectric layer over the gate 106 of the left branch drive transistor 32 and thereby isolated from gating by the underlying active region of the substrate 100. Note that as shown in Figure 5, the channel region 238 may be wider than the gate 106 if desired, provided the combination of the thickness of the sidewalls of the gate 106 and the alignment tolerances of the photolithography are sufficient to prevent the channel 238 from extending from above the top of the gate 106 to above a significant area of the active area of the substrate 100. In this undesirable case, the channel 238 would be gated by either the source or drain of the left branch drive transistor 32. A second polysilicon drain segment 240 is continuous with the channel 238 of the right branch thin film load transistor 42, and also continuous with second polysilicon $V^{CC}$ line 310.

The gate of the right branch drive transistor 34 is shown as segment 206 of a conductive structure also comprising a segment 118 which contacts the drain 104 of the left branch drive transistor 32 through the buried contact 116. The drain 104 of the left branch drive transistor 32 is also contacted by a source region 136 of the left branch thin film load transistor 40, fabricated in second polysilicon, through contact hole 136 to conductive segment 120 and thence through conductive segments 206 and 118 and the buried contact 116. The source 136 is continuous with an undoped second polysilicon section 138, which is disposed on a dielectric layer over the gate 206 of the right branch drive transistor 34 and thereby isolated from gating by the underlying active region of the substrate 100. Note that the channel region 138 may be wider than the gate 206 if desired, provided the combination of the thickness of the sidewalls of the gate 206 and the alignment tolerances of the photolithography are sufficient to prevent the channel 138 from extending from above the top of the gate 206 to above a significant area of the active area of the substrate 100. In this undesirable case, the channel 138 would be gated by either the source or drain of the left branch drive transistor 32. A second polysilicon drain segment 140 is continuous with the channel 138 of the left branch thin film load transistor 40, and also continuous with second polysilicon $V^{CC}$ line 310.

Many commercially available or generally known NMOS and CMOS processes are suitable for fabricating the SRAM cell 30. It will be appreciated that the fabrication of the SRAM cell 30 in accordance with the twin well CMOS process sequence described below is illustrative.

The SRAM cell 30 is fabricated on an N-type substrate which is cleaned and coated with a thin thermal stress-relief oxide film and a thicker silicon nitride film. A photoresisit is deposited, and the photoresist and the underlying silicon nitride and oxide films are patterned. A phosphorus implant is made to obtain the N-well regions of the integrated circuit. The photoresist is removed and the N-well regions are oxidized to provide a P-well mask. The remaining nitride and oxide layers are removed, and a boron implant is made to obtain the P-well regions of the integrated circuit. A stress relief oxide layer and a nitride layer are reformed.

Active areas are defined as follows. The oxide and nitride layers are patterned with a suitable active area mask (Figure 4), a P-field implant is made, and a thermal field oxide is grown between the active areas. A gate oxide of about 250 A thickness is formed over the active areas.

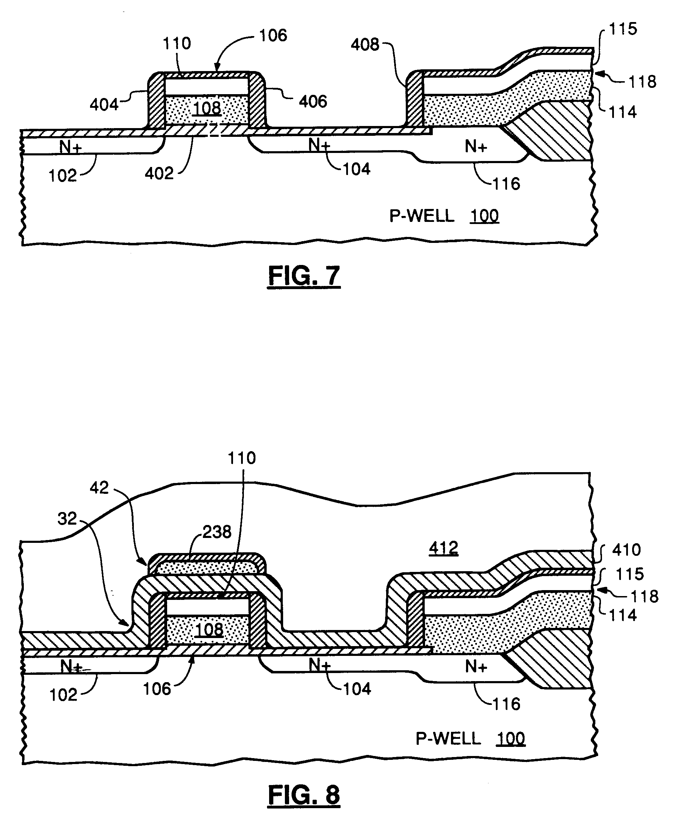

Conductive structures that function variously as gates, interconnects, and active area contacts are formed as follows. Refer to Figure 7, which shows a gate 106 and an interconnect and active area contact member 118. Gate oxide is patterned to form buried layer contact holes to buried contacts such as 116. A first polysilicon film of about 3000 A thickness is deposited using any suitable deposition equipment, such as, for example, a LPCVD tube such as available from Thermco Corporation, Los Angeles, at a deposition temperature of 615°C. The first polysilicon film is doped with phosphorus to a sheet resistance of about 17.5 ohms/square using any suitable equipment, such as, for example, a $POCl_3$ tube such as available from Thermco Corporation. Segments 108 and 114 are formed from this first polysilicon film. Following a deglaz and sulfuric acid clean, a tungsten silicide film of about 2000 A thickness is deposited using any suitable deposition equipment, such as, for example, a CVD reactor such as available from Genus Corporation, Mountain View, California. The target sheet resistance is about 43 ohms/square. Segments 110 and 115 are formed from this tungsten silicide film. The tungsten silicide and polysilicon layers, which are collectively known as polycide, are patterned in accordance with the polycide mask (Figure 4) to form conductive structures such as 106 and 118. An adequate thickness of oxide, such as, for example, about 150 A, is left over all active areas unprotected by the polycide structures. A silicide anneal and re-oxidation step is then performed at 900°C using a Thermco furnace, which adds about 110 A over the active area.

Source and drain regions are formed as follows. A 2000 A layer of low temperature oxide is deposited using any suitable equipment, such as, for example, a CVD reactor such as available from Anicon, Inc., San Jose, California. The resulting LTO film is anisotropically etched using any suitable equipment, such as, for example, the model 8310 RIE etcher available from Applied Materials, Inc., Santa Clara, California in order to remove all LTO film except for that on the sidewalls of the polycide structures such as 106 and 118. Sidewall spacers such as 404, 406 and 408 result. A layer of oxide, measuring about 100 A +/- 100A, is left over the active areas unprotected by the polycide structures. The N-well regions are masked by photoresist, and a suitable N-type dopant such as phosphorus, arsenic, or both are implanted into areas of the P-wells not protected by gate structures, their LTO sidewalls, or field oxide. For example, if both phosphorus and arsenic are used, suitable doses and energies include, for the phosphorus implant, doses in the range of 1.5 E14 through 2.5 E14 and energies in the range of 65 KeV through 75 KeV respectively; and for the arsenic implant, doses in the range of 6 E15 through 8 E15 and energies in the range of 60 KeV through 80 KeV respectively. The photoresist is stripped, and new photoresist is deposited to mask the P-well regions. A suitable P-type dopant such as boron difluoride is implanted into areas of the N-wells not protected by gate structures, their LTO sidewalls, or field oxide. Doses in the range of 3 E15 through 6 E15 and energies in the range of 60 KeV through 80 KeV are suitable. The photoresist is stripped.

Second poly features are fabricated as follows, with reference to Figure 8. A layer 410 of LTO is deposited to a thickness of about 2000 A using any suitable equipment, such as previously mentioned Anicon CVD reactor. The LTO film 410 is densified in any suitable equipment, such as the previously mentioned Thermco furnace. The principle considerations in selecting the dielectric material and its thickness are the effective gating of the thin film transistors 40 and 42 by the drive transistors 32 and 34 respectively, and the electrical integrity of the material between the gates of the drive transistors 32 and 34 and the channels of the thin film transistors 42 and 40 respectively. A mask step is performed at this time to etch contact holes through the LTO layer 410. A photoresist is patterned, and contact holes such as contact hole 234 (Figure 6) are etched through the densified LTO layer 410 in any suitable equipment, such as, for example, by plasma etch using the previously mentioned Applied Materials RIE etcher.

Next, a second polysilicon film is deposited to a thickness of about 2000 A using any suitable equipment, such as, for example, the previously mentioned Thermco LPCVD tube. A layer of photoresist is deposited over the second polysilicon layer, and is suitably patterned in accordance with a poly II mask (Figure 4) and etched to define second polysilicon features, including sources, drains, and channels of thin film transistors such as 40. A suitable etching technique is a plasma poly etch using the Model 490 plasma etcher available from LAM Research Corporation, Fremont, California. The remaining portions of the second polysilicon layer 124 are reoxidized to about 150 A thickness, and overlaid by a layer of photoresist 410 which is suitably patterned and etched in accordance with a poly II implant mask (Figure 4) to expose conductive sections such as prospective source and drain regions of the remaining portions of the second polysilicon layer. Channel segments such as 238 are protected by photoresist 412. A poly II implant is made using any suitable dopant such as, for example, phosphorus at a dose of 8.0E15 and an energy of 50 KeV.

First metal features are fabricated as follows. A layer 414 of borophosphosilicate glass ("BPSG") is deposited and reflowed to a suitable thickness, which is on the order of from 5500 A to 7000 A. A masking step is followed by various etching steps to make contact holes such as contact hole 230 through the BPSG layer 414 and underlying layers, as desired. A layer of a suitable first metal such as aluminum is deposited to a thickness of, for example, 6500 A and suitably patterned to form interconnect lines such as the bit complement line 306 (Figures 5 and 6). Subsequent layers (not shown) are deposited to planarize the chip, provide a second metal layer, and pacify the chip, as is well known in the art.

The channels of the thin film load transistors 40 and 42 are subject to gating by the bit lines. As shown in Figure 6, the bit complement line 306 runs over the channel 238 of the right branch thin film load transistor 42. The proximity of line 306 to the channel 238 has no effect when line 306 is LOW. When line 306 goes HIGH in order to effect a RESET, the effect may be advantageous or disadvantageous, depending on the state of the memory cell 30. When the memory cell 30 is RESET, the right branch drive transistor 34 is OFF and the channel 238 is conductive. A HIGH on line 306 makes channel 238 even more conductive and stability is enhanced. When the memory cell 30 is SET, the right branch drive transistor 34 is ON and the channel 238 is not conductive. A HIGH on line 306 makes channel 238 conductive and adversely affects the low standby current.

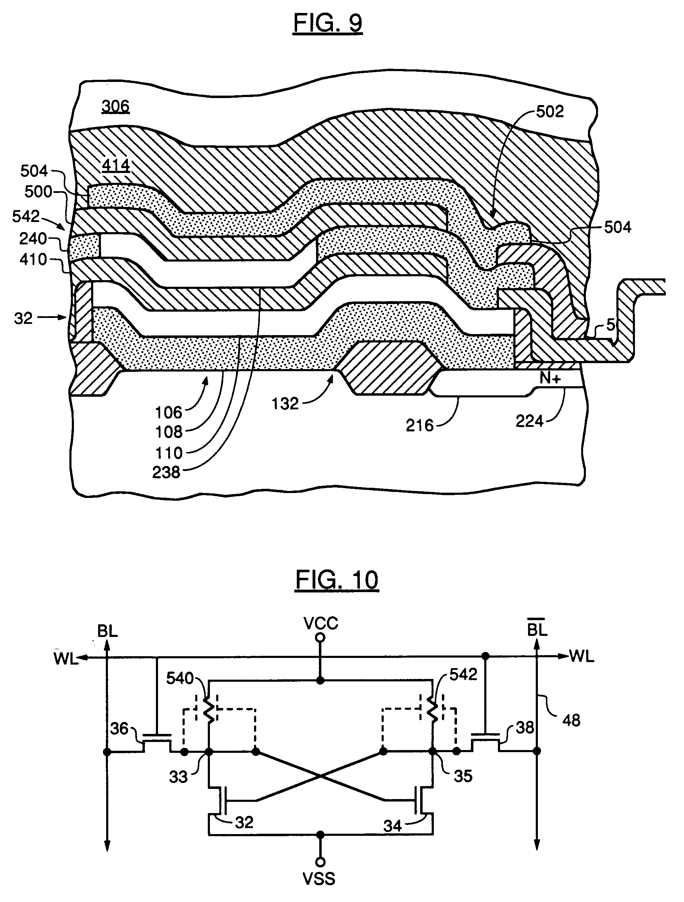

The effect described above tends to be relatively minor when measured over the entire memory. Nonetheless, it may be reduced or avoided if desired. In one approach, the bit lines are rerouted so that they do not pass over the channel regions of the thin film transistors 40 and 42. Figure 5 shows that bit complement line 306 is somewhat offset with respect to the channel region 238. Line 306 may be fully offset relative to channel 238 to eliminate vertical overlap and minimize the enhancement of carriers in the channel 238. In another approach, illustrated in Figure 9, a conductive segment 504 is provided between the line 306 and the channel 238, and is connected to the source 236 of the thin film load transistor 42 through contact hole 502. The conductive segment 504 is patterned from a third polysilicon layer, deposited over a LTO oxide film 500. Other conductive materials such as polycide and metal are suitable as well. The segment 504 shields the channel 238 from the line 306, and both segment 504 and gate 106 control the enhancement of carriers in the channel 238. The equivalent circuit for such a memory cell is shown in Figure 10, in which thin film load transistors 540 and 542 are modified substantially in the manner shown in Figure 9. In a variation, the conductive segment 540 is connected to potential $V_{SS}$.

While our invention has been described with respect to the embodiments set forth above, other embodiments and variations not described herein are within the scope of my invention. For example, our invention is not to be considered limited to the specific layout described, or limited to the ranges or specific values of process parameters specified, as specific parameter values depend on the characteristics desired of the integrated circuit devices in a manner well known in the art. Accordingly, other embodiments, variations and improvements not described herein are to be considered within the scope of our invention as defined by the following claims.

**Claims**

1. A static random access memory cell comprising:
    a first field effect transistor (32) having first and second majority carrier regions and a gate;
    a second field effect transistor (34) having first and second majority carrier regions and a gate, the first and second transistors being cross coupled, and the respective first majority carrier regions thereof being coupled to a first potential and the respective second majority carrier regions thereof being coupled to a second potential;
    a third field effect transistor (40;540) having a channel connection between the first majority carrier region of the first transistor and the first potential, the third transistor being commonly gated with the second transistor; and
    a fourth field effect transistor (42;542) having a channel connected between the first majority carrier region of the second transistor and the first potential, the fourth transistor being commonly gated with the first transistor.

2. A memory cell as claimed in claim 1 wherein the third transistor is principally gated by the gate of the second transistor, and wherein the fourth transistor is principally gated by the gate of the first transistor.

3. A memory cell as claimed in claim 2 wherein:
    the first majority carrier regions of the first and second transistors are drains;
    the second majority carrier regions of the first and second transistors are sources;
    the first potential is $V_{CC}$; and
    the second potential is $V_{SS}$.

4. A memory cell as claimed in claim 1, 2 or 3 wherein said first and second transistors are NMOS transistors;
    the third and fourth transistors are thin film NMOS transistors having respective gates;
    the gates of the first and fourth transistors are common, and
    the gates of the second and third transistors are common.

5. A memory cell as claimed in claim 1, 2, 3 or 4 wherein the first and second transistors (32,34) are drive transistors and the third and fourth transistors are load transistors, and wherein:
    a first access transistor (36) is coupled between a bit line and the first majority carrier region of the first transistor, the first access transistor being controlled by a word line, and
    a second access transistor (38) is coupled between a bit complement line and the first majority carrier region of the second transistor, the second access transistor being controlled by the word line.

6. A static random access MOSFET memory cell, comprising:
    a first drive MOSFET (32) having a source connected to potential $V_{SS}$, a drain and a gate;
    a second drive MOSFET (34) having a source connected to potential $V_{SS}$, a drain and a gate, the gate of the first drive MOSFET being connected to the drain of the second drive MOSFET, and the gate of second drive MOSFET being connected to the drain of the first drive MOSFET;

a first thin film load transistor (40;540) having a gate, a source connected to the drain of said first drive transistor, and a drain connected to potential $V_{CC}$ , the gate of the first thin film load transistor and the gate of the second drive transistor being common;

a second thin film load transistor (42;542) having a gate, a source connected to the drain of the second drive transistor, and a drain connected to potential $V_{CC}$ , the gate of the second thin film load transistor and the gate of the first drive transistor being common;

a first access MOSFET (36) having a first source/drain connected to the drain of said first drive MOSFET, a second source/drain connected to a bit line, and a gate connected to a word line; and

a second access MOSFET (38) having a first source/drain connected to the drain of the second drive MOSFET, a second source/drain connected to a bit complement line, and a gate connected to the word line.

7. A static random access MOSFET memory cell, comprising:

a first drive transistor (32) having a channel disposed in an active area and a gate structure including a first film overlying the first drive transistor channel;

a second drive transistor (34) having a channel disposed in an active area and a gate structure including a first film overlying the second drive transistor channel;

a first load transistor (40;540) having a channel of a second film confined to an area overlying a portion of the gate of the second drive transistor, the first drive transistor having a doped majority carrier region conductively coupled to a doped majority carrier region of the first load transistor and controllably conductively coupled to a bit line; and

a second load transistor (42;542) having a channel of a second film confined to an area overlying a portion of the gate of the first drive transistor, the second drive transistor having a doped majority carrier region conductively coupled to a doped majority carrier region of the second load transistor and controllably conductively coupled to a bit complement line.

8. A memory cell as claimed in claim 7 wherein the portion of the gate of the first drive transistor overlain by the channel of the second load transistor is the entire gate, and wherein the portion of the gate of the second drive transistor overlain by the channel of the first load transistor is the entire gate.

9. A memory cell as claimed in claim 7 wherein the first film of the respective gate structures of the first and second drive transistors (32,34) is a polycide.

10. A memory cell as claimed in claim 9 wherein the polycide is tungsten silicide overlying doped polysilicon.

11. A memory cell as claimed in claim 7, 8 or 9 wherein each of the respective gate structures of the first and second drive transistors comprises a first film having sidewalls, and spacers disposed on the sidewalls.

12. A memory cell as claimed in any one of claims 7-11 wherein the second film of the respective channels of the first and second load transistors (40,42) is polysilicon.

13. A memory cell as claimed in any one of claims 7-12 wherein the respective doped majority carrier region of said first and second load transistors is doped second film.

14. A memory cell as claimed in claim 13 wherein the second film of the rspective channels of the first and second load transistors is undoped polysilicon, and the second film of the respective doped majority carrier region of the first and second load transistors is doped polysilicon.

15. A memory cell as claimed in any one of claims 7-14 comprising:

a first segment (504) of a conductive third film disposed between the bit line and the channel of the first load transistor (540), the bit line overlying the channel of the first load transistor; and

a second segment of a conductive third film disposed between the bit complement line and the channel of the second load transistor (542), the bit complement line overlying the channel of the second load transistor.

16. A memory cell as claimed in claim 15 wherein the first segment is connected to the gate of the second drive transistor (34), and wherein the second segment is connected to the gate of the first drive transistor (32).

17. A memory cell as claimed in claim 15 or 16 wherein the first and second segments are connected to a reference potential.

18. A memory cell as claimed in claim 15, 16 or 17 wherein the material of the third conductive film is doped polysilicon, a polycide, or a metal.

**FIG. 1**
(PRIOR ART)

**FIG. 2**
(PRIOR ART)

9

**FIG. 3**

**FIG. 5**

**FIG. 4**

**FIG. 6**

EP 0 471 126 A2

110    106
404    108    406
N+    402
102    N+    104
116
P-WELL    100

**FIG. 7**

408    115
118
114

110
42    238
32
412    410
115
108    118
114
N+    106    N+    N+
102    104
116
P-WELL    100

**FIG. 8**

## FIG. 9

## FIG. 10